# EUROPEAN PATENT APPLICATION

(11) **EP 4 276 804 A1**
(43) Date of publication of application: **15.11.2023**
(21) Application number: 21917774.8
(22) Date of filing: 28.12.2021
(51) Int. Cl.: G09F 9/30, H01L 27/32, G02B 3/02, G02B 5/20, H05B 33/04, H05B 33/12, H01L 51/50, H05B 33/22

(54) **DISPLAY DEVICE AND ELECTRONIC APPARATUS**

(30) Priority: 08.01.2021 JP 2021002426
(71) Applicant: Sony Group Corporation, Tokyo 108-0075 (JP); Sony Semiconductor Solutions Corporation, Atsugi-shi, Kanagawa 243-0014 (JP)
(72) Inventor: SUEMASU, Atsushi, Atsugi-shi, Kanagawa 243-0014 (JP); SUGI, Keiji, Tokyo 108-0075 (JP)
(74) Representative: D Young & Co LLP
(86) International application number: PCT/JP2021/048892
(87) International publication number: WO 2022/149554

(57) **Abstract**

A display device and an electronic device capable of reducing color mixture while reducing a decrease in brightness and a decrease in a protective function of light emitting elements are provided.

A display device includes a substrate, a plurality of light emitting elements arranged two-dimensionally on the substrate and including a plurality of first electrodes, an organic layer arranged on the first electrodes, and a second electrode that covers the organic layer, a protective layer that covers the plurality of light emitting elements, and a plurality of color filters provided on an upper side of the protective layer, in which a plurality of subpixels corresponding to the plurality of respective light emitting elements is formed, a ring-shaped lens including a convex surface portion that is convex in a direction away from the substrate is provided in a peripheral edge portion of each of the subpixels at a position from which a position across the color filters of an adjacent subpixel adjacent to each of the subpixels is excluded in a plan view of the subpixels, and a refractive index of the lens is higher than a refractive index of an outer portion of the lens in contact with the convex surface portion.

## Description

### TECHNICAL FIELD

The present disclosure relates to a display device and an electronic device using the display device.

### BACKGROUND ART

In a display device including light emitting elements having an organic layer (hereinafter, simply referred to as a display device), light generated in a light emitting element may enter not only a color filter provided in a subpixel corresponding to the light emitting element but also color filters of adjacent subpixels adjacent to the subpixel. In this case, a state in which light is leaked not only to the subpixel to be caused to emit light but also to the adjacent subpixels (hereinafter, the state may be referred to as light leakage) may be caused, and color mixture may occur on a display screen. In order to reduce such light leakage and color mixture, forming a light shielding layer between adjacent color filters, for example, as disclosed in Patent Document 1, is known. In addition, shortening a distance between the light emitting elements and color filters by thinning a protective layer formed between the light emitting elements and the color filters using an atomic layer deposition (ALD) technology is known.

### CITATION LIST

### PATENT DOCUMENT

Patent Document 1: Japanese Patent Application Laid-Open No. 2015-162588

### SUMMARY OF THE INVENTION

### PROBLEMS TO BE SOLVED BY THE INVENTION

In a case where a light shielding layer is formed in a display device, there is room for improvement in terms of reducing a decrease in brightness of the display device. Furthermore, in a case where a protective film is thinned in the display device, there is room for improvement in terms of reducing deterioration of a protective function of the light emitting elements.

The present disclosure has been made in view of the above-described points, and an object of the present disclosure is to provide a display device and an electronic device capable of reducing color mixture while reducing a decrease in brightness and a decrease in a protective function of light emitting elements.

### SOLUTIONS TO PROBLEMS

The present disclosure is, for example,
(1) a display device including
   a substrate,
   a plurality of light emitting elements arranged two-dimensionally on the substrate and including a plurality of first electrodes, an organic layer arranged on the first electrodes, and a second electrode that covers the organic layer,
   a protective layer that covers the plurality of light emitting elements, and
   a plurality of color filters provided on an upper side of the protective layer,
   in which a plurality of subpixels corresponding to the plurality of respective light emitting elements is formed,
   a ring-shaped lens including a convex surface portion that is convex in a direction away from the substrate is provided in a peripheral edge portion of each of the subpixels at a position from which a position across the color filters of an adjacent subpixel adjacent to each of the subpixels is excluded in a plan view of the subpixels, and
   a refractive index of the lens is higher than a refractive index of an outer portion of the lens in contact with the convex surface portion.

The present disclosure may be
(2) a display device including
a first substrate including
a drive substrate,
a plurality of light emitting elements arranged two-dimensionally on the drive substrate and including a plurality of first electrodes, an organic layer arranged on the first electrodes, and a second electrode that covers the organic layer, and
a protective layer that covers the plurality of light emitting elements,
a second substrate including a counter substrate arranged so as to face the drive substrate and a plurality of color filters formed on the counter substrate, and
a sealing resin layer that joins the protective layer of the first substrate and the color filters of the second substrate to each other,
in which a plurality of subpixels corresponding to the plurality of respective light emitting elements is formed,
a ring-shaped lens including a convex surface portion that is convex in a direction away from the first substrate is provided in a peripheral edge portion of each of the subpixels at a position from which a position across the color filters of an adjacent subpixel adjacent to each of the subpixels is excluded in a plan view of the subpixels, and
a refractive index of the lens is higher than a refractive index of an outer portion of the lens in contact with the convex surface portion.

The present disclosure may be
(3) a display device including
a first substrate including
a drive substrate,
a plurality of light emitting elements arranged two-dimensionally on the drive substrate and including a plurality of first electrodes, an organic layer arranged on the first electrodes, and a second electrode that covers the organic layer, and
a protective layer that covers the plurality of light emitting elements,
a second substrate including a counter substrate arranged so as to face the drive substrate and a plurality of color filters formed on the counter substrate, and
a sealing resin layer that joins the protective layer of the first substrate and the color filters of the second substrate to each other,
in which a plurality of subpixels corresponding to the plurality of respective light emitting elements is formed,
a ring-shaped lens including a convex surface portion that is convex in a direction away from the second substrate is provided in a peripheral edge portion of each of the subpixels at a position from which a position across the color filters of an adjacent subpixel adjacent to each of the subpixels is excluded in a plan view of the subpixels, and
a refractive index of the lens is higher than a refractive index of an outer portion of the lens in contact with the convex surface portion.

Furthermore, the present disclosure may be, for example, (4) an electronic device including the display device according to (1) described above.

### BRIEF DESCRIPTION OF DRAWINGS

Fig. 1 is a cross-sectional view for describing an implementation example of a display device according to a first embodiment.
Fig. 2A is a plan view for describing one of implementation examples of the display device. Fig. 2B is a partially enlarged plan view in which a portion of an area XS surrounded by a broken line in Fig. 2A is enlarged.
Figs. 3A and 3B are plan views illustrating examples of a layout of subpixels and ring-shaped lenses of the display device.
Figs. 4A and 4B are cross-sectional views illustrating implementation examples of the ring-shaped lenses.
Figs. 5A, 5B, and 5C are cross-sectional views illustrating implementation examples of the ring-shaped lenses.
Fig. 6 is a cross-sectional view for describing an implementation example of a display device according to a second embodiment.
Fig. 7 is a cross-sectional view for describing an implementation example of a display device according to a third embodiment.
Fig. 8 is a cross-sectional view for describing an implementation example of a display device according to a fourth embodiment.
Fig. 9 is a cross-sectional view for describing an implementation example of a display device according to a fifth embodiment.
Fig. 10A is a plan view illustrating a layout of subpixels and ring-shaped lenses of the display device of Fig. 9. Figs. 10B and 10C are plan views illustrating examples of the layout of the subpixels and the ring-shaped lenses of the display device according to the fifth embodiment.
Fig. 11 is a cross-sectional view for describing an implementation example of a display device according to a sixth embodiment.
Fig. 12 is a cross-sectional view for describing an implementation example of the display device according to the sixth embodiment.
Fig. 13 is a cross-sectional view for describing an implementation example of a display device according to a seventh embodiment.
Figs. 14A and 14B are diagrams for describing implementation examples of an electronic device using a display device.
Fig. 15 is a diagram for describing an implementation example of the electronic device using a display device.
Fig. 16 is a diagram for describing an implementation example of the electronic device using a display device.

### MODE FOR CARRYING OUT THE INVENTION

Hereinafter, an implementation example and the like according to the present disclosure will be described with reference to the drawings. Note that the description will be given in the following order. In the description and the drawings, configurations having substantially the same functional configuration are denoted by the same reference numerals, and redundant descriptions are omitted.

Note that the description will be made in the following order.
1. First Embodiment
2. Second Embodiment
3. Third Embodiment
4. Fourth Embodiment
5. Fifth Embodiment
6. Sixth Embodiment
7. Seventh Embodiment
8. Application Examples

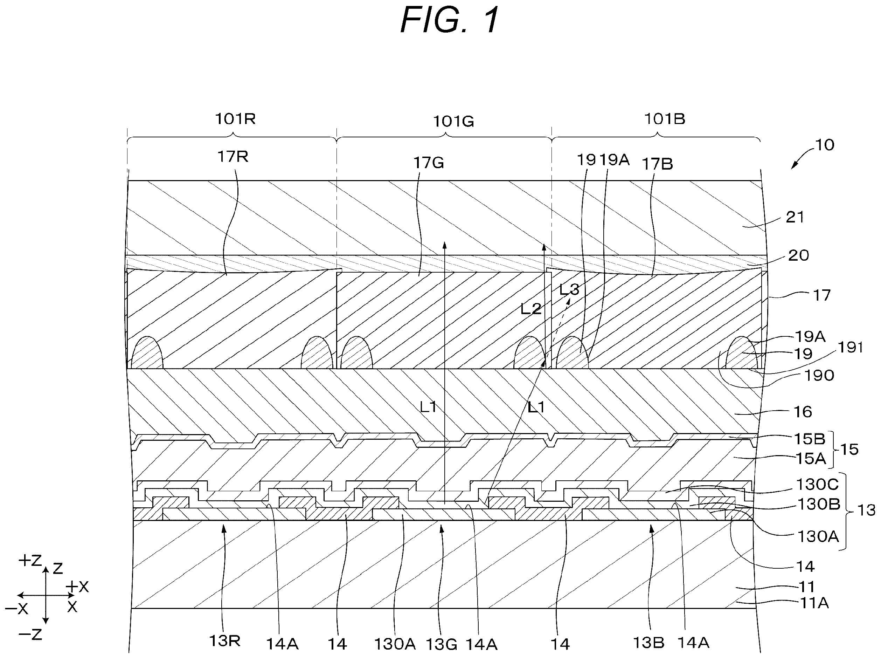

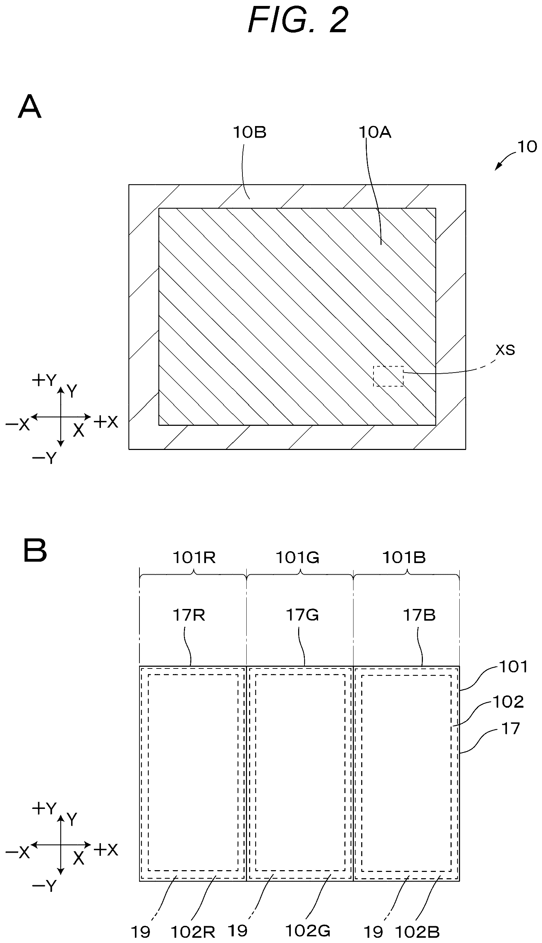

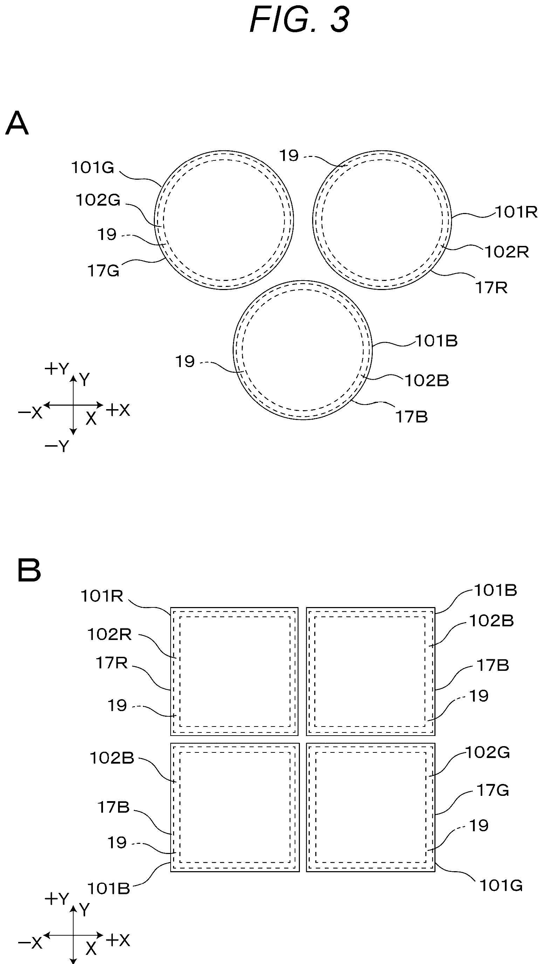

The following description is a preferred specific example of the present disclosure, and the content of the present disclosure is not limited to these embodiments and the like. Furthermore, in the following description, directions of front and back, left and right, up and down, and the like are indicated in consideration of convenience of description, but the content of the present disclosure is not limited to these directions. In examples of Figs. 1 and 2, it is assumed that the Z-axis direction is the up and down direction (upper side is in a + Z direction, and lower side is in a -Z direction), the X-axis direction is the front and back direction (front side is in a + X direction, and back side is in a -X direction), and the Y-axis direction is the left and right direction (right side is in a + Y direction, and left side is in a -Y direction), and the description will be made based on this. This similarly applies to Figs. 3 to 13. A relative magnitude ratio of the size and thickness of each layer illustrated in each drawing of Fig. 1 and the like is described for convenience, and do not limit actual magnitude ratios. This similarly applies to each drawing of Figs. 2 to 16 regarding the definition and the magnitude ratio regarding these directions.

### [1 First Embodiment]

### [1-1 Configuration of Display Device]

Fig. 1 is a cross-sectional view illustrating a configuration example of an organic electroluminescence (EL) display device 10 (hereinafter simply referred to as a "display device 10") according to an embodiment of the present disclosure. The display device 10 includes a drive substrate 11, a plurality of light emitting elements 13, a protective layer 15, a plurality of color filters 17, and ring-shaped lenses 19.

The display device 10 is a top emission type display device. In the display device 10, the drive substrate 11 is located on the back surface side of the display device 10, and a direction from the drive substrate 11 toward the light emitting elements 13 (+Z direction) is a front surface side (display surface 10A side, upper surface side) direction of the display device 10. In the following description, in each layer included in the display device 10, a surface on the display surface 10A side of the display device 10 is referred to as a first surface (upper surface), and a surface on the back surface side of the display device 10 is referred to as a second surface (lower surface).

### (Configuration of Subpixels)

In the example of the display device 10 illustrated in Fig. 1, one pixel is formed by a combination of a plurality of subpixels corresponding to a plurality of color types. In this example, three colors of red, green, and blue are determined as a plurality of color types, and three types of a subpixel 101R, a subpixel 101G, and a subpixel 101B are provided as subpixels. The subpixel 101R, the subpixel 101G, and the subpixel 101B are a red subpixel, a green subpixel, and a blue subpixel, respectively, and display red, green, and blue, respectively. However, the example of Fig. 1 is an example, and the display device 10 is not limited to a case of including a plurality of subpixels corresponding to a plurality of color types. One color type may be used, or a pixel may be formed without including a subpixel. Furthermore, the wavelengths of light corresponding to the respective color types of red, green, and blue can be determined as, for example, wavelengths in a range of 610 nm to 650 nm, a range of 510 nm to 590 nm, and a range of 440 nm to 480 nm, respectively. Furthermore, in the example of Fig. 1, the layout of the subpixels 101R, 101G, and 101B is a stripe-shaped layout as illustrated in Fig. 2B. Fig. 2B is a view illustrating a state in which a partial area in the display surface 10A of Fig. 2A is enlarged. Fig. 2A is a view for describing the display surface 10A of the display device 10.

In the following description, in a case where the subpixels 101R, 101G, and 101B are not particularly distinguished, a word referred to subpixel 101 is used.

A peripheral edge portion 102 of a subpixel 101 refers to a portion having a predetermined width from the outer edge of a portion defined as the subpixel 101 toward the inside in a plan view of the display surface 10A. The layout of subpixels 101 is determined in advance, and the layout of the light emitting elements 13 is determined according to the layout of the subpixels 101.

Furthermore, in a case where a predetermined subpixel is selected, adjacent subpixels, which are to be described below, adjacent to the subpixel 101 are subpixels adjacent to the subpixel in a two-dimensional arrangement. For example, in the example illustrated in Fig. 1, as illustrated in Fig. 2B, adjacent subpixels are the subpixel 101R and the subpixel 101B for the subpixel 101G. In this case, color filters of the adjacent subpixels to be described below is a color filter of the subpixel 101R (red filter 17R) and a color filter of the subpixel 101B (blue filter 17B). As illustrated in Figs. 2B, 3A, 3B, and the like, formation portions of the individual subpixels 101 may have shapes that are roughly matched with formation portions of individual color filters 17, or may have shapes that are not matched with the formation portions of the color filters 17.

### (Drive Substrate)

The drive substrate 11 is provided with various circuits for driving the plurality of light emitting elements 13 on a substrate 11A. Examples of the various circuits include a drive circuit that controls driving of the light emitting elements 13 and a power supply circuit that supplies power to the plurality of light emitting elements 13 (none of which are illustrated).

The substrate 11A may be formed by, for example, glass or resin having low moisture and oxygen permeability, or may be formed by a semiconductor in which a transistor or the like is easily formed. Specifically, the substrate 11A may be a glass substrate, a semiconductor substrate, a resin substrate, or the like. The glass substrate includes, for example, high strain point glass, soda glass, borosilicate glass, forsterite, lead glass, quartz glass, or the like. The semiconductor substrate includes, for example, amorphous silicon, polycrystalline silicon, monocrystalline silicon, or the like. The resin substrate includes, for example, at least one selected from a group including polymethyl methacrylate, polyvinyl alcohol, polyvinyl phenol, polyethersulfone, polyimide, polycarbonate, polyethylene terephthalate, polyethylene naphthalate, and the like.

A plurality of contact plugs (not illustrated) for connecting the light emitting elements 13 and the various circuits provided on the substrate 11A is provided on the first surface of the drive substrate 11.

### (Light Emitting Elements)

In the display device 10, the plurality of light emitting elements 13 is provided on the first surface of the drive substrate 11. In the example of Fig. 2, as the plurality of light emitting elements 13, individual light emitting elements 13R, 13G, and 13B are formed so as to correspond to the individual subpixels 101R, 101G, and 101B. In the present specification, in a case where the types such as the light emitting elements 13R, 13G, and 13B are not particularly distinguished, a word referred to light emitting element 13 is used. The plurality of light emitting elements 13 is, for example, two-dimensionally arranged in a prescribed arrangement pattern such as a matrix shape or the like. In the example of Fig. 2A, the plurality of light emitting elements 13 is two-dimensionally arranged in predetermined two directions (X-axis direction and Y-axis direction in Fig. 2A). Fig. 2A is a plan view for describing an implementation example of the display surface 10A of the display device 10. In Fig. 2A, a reference numeral 10B denotes an area outside the display surface 10A.

Each of the light emitting elements 13 is formed to emit white light. Each of the light emitting elements 13 is, for example, a white organic light-emitting diode (OLED) or a white micro-OLED (MOLED). In the present embodiment, as a coloring method in the display device 10, a method using the light emitting elements 13 and the color filters 17 is used.

Each of the light emitting elements 13 includes first electrodes 130A, an organic layer 130B, and a second electrode 130C. The first electrodes 130A, the organic layer 130B, and the second electrode 130C are laminated in this order from the drive substrate 11 side toward a counter substrate 21.

### (First Electrodes)

In the display device 10, a plurality of first electrodes 130A is provided on the first surface side of the drive substrate 11. The first electrodes 130A are electrically separated for the respective subpixels 101 by an insulating layer 14 to be described below. Each of the first electrodes 130A is an anode. Each of the first electrode 130A also preferably includes a function as a reflection layer. From this viewpoint, each of the first electrodes 130A preferably has as high a reflectance as possible. Moreover, each of the first electrodes 130A preferably includes a material having a large work function in order to enhance luminous efficiency.

Each of the first electrodes 130A includes at least one of a metal layer or a metal oxide layer. For example, each of the first electrodes 130A may include a single layer film of a metal layer or a metal oxide layer, or a laminated film of a metal layer and a metal oxide layer. In a case where each of the first electrodes 130A includes the laminated film, the metal oxide layer may be provided on the organic layer 130B side, or the metal layer may be provided on the organic layer 130B side, but from the viewpoint of including a layer having a high work function adjacent to the organic layer 130B, the metal oxide layer is preferably provided on the organic layer 130B side.

The metal layer includes, for example, at least one metal element selected from a group including chromium (Cr), gold (Au), platinum (Pt), nickel (Ni), copper (Cu), molybdenum (Mo), titanium (Ti), tantalum (Ta), aluminum (Al), magnesium (Mg), iron (Fe), tungsten (W), and silver (Ag). The metal layer may include the at least one metal element described above as a constituent element of an alloy. Specific examples of the alloy include an aluminum alloy and a silver alloy. Specific examples of the aluminum alloy include, for example, AlNd and AlCu.

The metal oxide layer includes, for example, at least one of a mixture of indium oxide and tin oxide (ITO), a mixture of indium oxide and zinc oxide (IZO), or titanium oxide (TiO).

### (Second Electrode)

In the light emitting element 13, the second electrode 130C is provided to face the first electrodes 130A. The second electrode 130C is provided as an electrode common to all the subpixels 101. The second electrode 130C is a cathode. The second electrode 130C is a transparent electrode having transmissivity to light generated in the organic layer 130B. Here, the transparent electrode also includes a semi-transmissive reflecting layer. The second electrode 130C preferably includes a material having as high transmissivity as possible and a small work function in order to enhance luminous efficiency.

The second electrode 130C includes at least one of a metal layer or a metal oxide layer. More specifically, the second electrode 130C includes a single layer film of a metal layer or a metal oxide layer, or a laminated film of a metal layer and a metal oxide layer. In a case where the second electrode 130C includes the laminated film, the metal layer may be provided on the organic layer 130B side, or the metal oxide layer may be provided on the organic layer 130B side, but from the viewpoint of including a layer having a low work function adjacent to the organic layer 130B, the metal layer is preferably provided on the organic layer 130B side.

The metal layer includes, for example, at least one metal element selected from a group including magnesium (Mg), aluminum (Al), silver (Ag), calcium (Ca), and sodium (Na). The metal layer may include the at least one metal element described above as a constituent element of an alloy. Specific examples of the alloy include an MgAg alloy, an MgAl alloy, an AlLi alloy, and the like. The metal oxide includes, for example, at least one of a mixture of indium oxide and tin oxide (ITO), a mixture of indium oxide and zinc oxide (IZO), or zinc oxide (ZnO).

### (Organic Layer)

The organic layer 130B is provided between the first electrodes 130A and the second electrode 130C. The organic layer 130B is provided as an organic layer common to all the subpixels. The organic layer 130B is formed to emit white light. However, this does not prohibit an emission color of the organic layer 130B from being other than white, and colors including red, blue, green, and the like may be adopted. That is, the emission color of the organic layer 130B may be, for example, any one of white, red, blue, or green.

The organic layer 130B has a configuration in which a hole injection layer, a hole transport layer, a light emitting layer, and an electron transport layer are laminated in this order from the first electrodes 130A toward the second electrode 130C. Note that, the configuration of the organic layer 130B is not limited thereto, and layers other than the light emitting layer are provided as necessary.

The hole injection layer is a buffer layer for enhancing hole injection efficiency into the light emitting layer and reducing leakage. The hole transport layer is for enhancing hole transport efficiency to the light emitting layer. The light emitting layer generates light by electrons and holes being combined by an electric field being applied. The light emitting layer is an organic light emitting layer including an organic light emitting material. The electron transport layer is for enhancing electron transport efficiency to the light emitting layer. An electron injection layer may be provided between the electron transport layer and the second electrode 130C. The electron injection layer is for enhancing electron injection efficiency.

### (Insulating Layer)

In the display device 10, as illustrated in Fig. 1, the insulating layer 14 is preferably provided on the first surface side of the drive substrate 11. The insulating layer 14 is provided between the adjacent first electrodes 130A, and electrically separates each of the first electrodes 130A for the respective light emitting elements 13 (that is, for the respective subpixels 101). Furthermore, the insulating layer 14 includes a plurality of openings 14A, and the first surfaces of the first electrodes 130A (surfaces facing the second electrode 130C) are exposed from the openings 14A. Note that, in the example of Fig. 1 and the like, the insulating layer 14 covers areas from peripheral edge portions to the side surfaces (end surfaces) of the first surfaces of the separated first electrodes 130A. Furthermore, in this case, each of the openings 14A is arranged on the first surface of each of the first electrodes 130A. At this time, the first electrodes 130A are exposed from the openings 14A, and these exposed areas define light emitting areas of the light emitting elements 13. In the present specification, the peripheral edge portions of the first surfaces of the first electrodes 130A refer to areas having a predetermined width from the outer peripheral edges on the first surface sides of the individual first electrodes 130A toward the inside of the first surfaces. Furthermore, in such an example of Fig. 1, portions covered with the insulating layer 14 on the first surfaces of the first electrodes 130A are formed in peripheral edge portions 102 of the subpixels 101, and the peripheral edges of the openings 14A are located in the peripheral edge portions 102.

The insulating layer 14 includes, for example, an organic material or an inorganic material. The organic material includes, for example, at least one of polyimide or acrylic resin. The inorganic material includes, for example, at least one of silicon oxide, silicon nitride, silicon oxynitride, or aluminum oxide.

### (Protective Layer)

The protective layer 15 is formed on the first surface of the second electrode 130C. The protective layer 15 shields the light emitting elements 13 from the outside air, and prevents moisture infiltration into the light emitting elements 13 from the external environment. Furthermore, in a case where the second electrode 130C includes a metal layer, the protective layer 15 may include a function of preventing oxidation of the metal layer.

The protective layer 15 includes an insulating material. As the insulating material, for example, thermosetting resin or the like can be used. In addition, the insulating material may be SiO, SiON, AlO, TiO, or the like. In this case, examples of the protective layer 15 include a CVD film including SiO, SiON, or the like, an ALD film including AlO, TiO, SiO, or the like, and the like. The protective layer 15 may be formed as a single layer or may be formed in a state where a plurality of layers is laminated. In the example of Fig. 1, the protective layer 15 is formed in a state where a first protective layer 15A and a second protective layer 15B are laminated. At this time, the first protective layer 15A preferably includes a CVD film, and the second protective layer 15B preferably includes an ALD film. Note that the CVD film indicates a film formed using chemical vapor deposition. The ALD film indicates a film formed using atomic layer deposition.

### (Flattening Layer)

A flattening layer 16 is preferably provided on the first surface of the protective layer 15. Since the flattening layer 16 is formed, the lenses 19 can be accurately formed on the flattening layer 16. Furthermore, since the flattening layer 16 is formed between the protective layer 15 and the color filters 17, the color filters 17 can be accurately provided due to the presence of the flattening layer 16 even in a case where unevenness is formed on the first surface of the protective layer 15. Furthermore, the flattening layer 16 preferably include a function of shielding the light emitting elements 13 from the outside air and preventing moisture infiltration into the light emitting elements 13 from the external environment together with the protective layer 15.

Examples of a material included in the flattening layer 16 include, for example, ultraviolet curable resin, thermosetting resin, and the like.

### (Color Filters)

The color filters 17 are provided on the first surface side (upper side, +Z direction side) of the protective layer 15, and are provided on the flattening layer 16 in the example of Fig. 1. Furthermore, each of the color filters 17 described in the first embodiment is an on chip color filter (OCCF). Examples of the color filters 17 include, for example, a red color filter (red filter 17R), a green color filter (green filter 17G), and a blue color filter (blue filter 17B) as illustrated in the example of Fig. 1. The red filter 17R, the green filter 17G, and the blue filter 17B are provided so as to face the light emitting element 13R for a red subpixel, the light emitting element 13G for a green subpixel, and the light emitting element 13B for a blue subpixel, respectively. Therefore, white light emitted from each of the light emitting elements 13R, 13G, and 13B in the red subpixel 101R, the green subpixel 101G, and the blue subpixel 101B passes through the red filter 17R, the green filter 17G, and the blue filter 17B described above, so that red light, green light, and blue light are emitted from the display surface 10A.

Note that the example of Fig. 1 is an example, and the types of the color filters 17 are not limited to a combination of three types of red, green, and blue. For example, the types of the color filters 17 may be a combination of four types of red, green, blue, and white.

### (Arrangement of Color Filters)

In the example of Fig. 1, the arrangement of the color filters 17 is arrangement in which the red filter 17R, the green filter 17G, and the blue filter 17B are repeatedly arranged in this order. Furthermore, in this example, each of the color filters 17 (red filter 17R, green filter 17G, and blue filter 17B) is formed in a stripe shape as illustrated in Figs. 1, 2B, and the like in accordance with the subpixels 101.

### (Lenses)

The display device 10 is provided with the ring-shaped lenses 19. In the example of Fig. 1, a lens 19 is arranged in each of the subpixels 101, and a plurality of lenses 19 is provided as a whole. Each of the lenses 19 has a convex surface portion 19A that is convex in a direction away from the substrate 11A (direction away from the drive substrate 11). Specifically, in the example of Fig. 1, the convex surface portion 19A of each of the lenses 19 includes a convex curved surface.

### (Arrangement of Lenses in Plan View of Subpixels)

Regarding the arrangement of each of the lenses 19 in the plan view of the subpixels 101, each of the lenses 19 is provided at the position of the peripheral edge portion 102 of each of the subpixels 101. For example, as illustrated in Figs. 1 and 2B, a lens 19 provided in the green subpixel 101G is provided in a peripheral edge portion 102G of the green subpixel 101G. A lens 19 provided in the red subpixel 101R is provided in a peripheral edge portion 102R of the red subpixel 101R. A lens 19 provided in the blue subpixel 101B is provided in a peripheral edge portion 102B of the blue subpixel 101B.

Furthermore, each of the lenses 19 is arranged at a position from which a position across color filters 17 of adjacent subpixels adjacent to each other is excluded. For example, in the example of Fig. 1, the lens 19 provided in the green subpixel 101G is provided at a position from which the formation area of the red filter 17R of the subpixel 101R that is an adjacent subpixel adjacent to the green filter 17G is excluded. Moreover, the lens 19 provided in the green subpixel 101G is also provided at a position from which the formation area of the blue filter 17B of the subpixel 101B is excluded also for the subpixel 101B that is an adjacent subpixel adjacent to the green filter 17G. Therefore, as illustrated in Fig. 1, in a case where the green filter 17G, the red filter 17R, and the blue filter 17B are in contact with each other on the side surfaces, the lenses 19 are arranged so as not to cross boundaries of the green filter 17G, the red filter 17R, and the blue filter 17B.

Note that, in a case where the formation areas of the color filters 17 and the areas of the subpixels 101 are substantially matched, for example, the lens 19 provided in the green subpixel 101G is provided inside the green filter 17G along the peripheral edge of the green filter 17G in a plan view of the green subpixel 101G. This similarly applies to the lens 19 provided in the red subpixel 101G and the lens 19 provided in the blue subpixel 101B.

### (Position of Convex Surface Portions)

The lenses 19 are provided in the color filters 17 such that the color filters 17 serve as outer portions 190. The outer portions 190 indicate portions in contact with the convex surface portions 19A in the outer portions of the lenses 19. That is, in display device 10, the convex surface portions 19A of the lenses 19 are in contact with the color filters 17. Note that bottom surfaces 191 of the lenses 19 are in contact with the first surface of the flattening layer 16. The lenses 19 form the convex surface portions 19A in a direction away from the substrate 11A with the position of the first surface of the flattening layer 16 as a base end. Since the lenses 19 are formed on the first surface of the flattening layer 16, the lenses 19 can be formed more precisely.

### (Longitudinal Cross-Sectional Shape of Lenses)

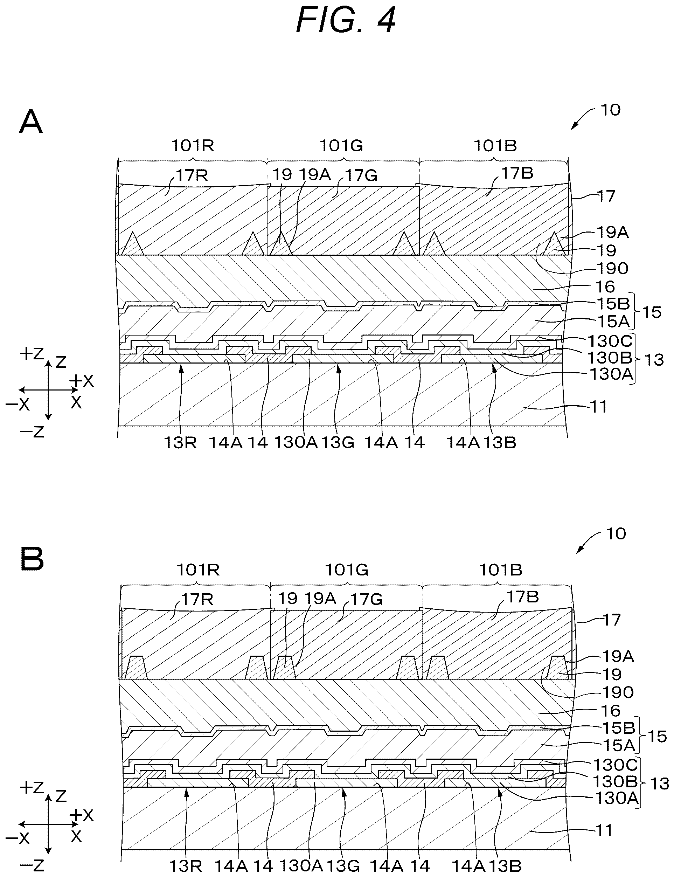

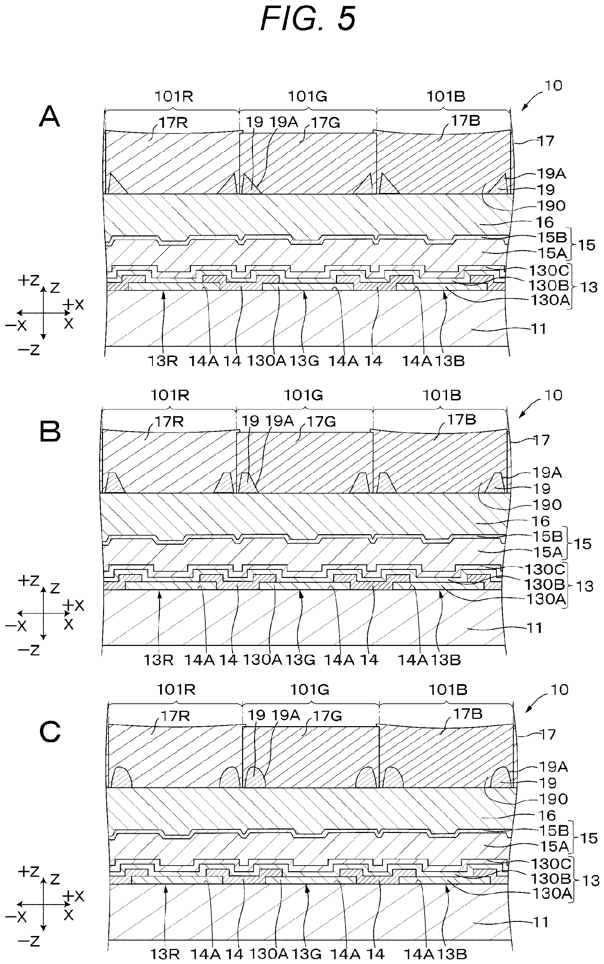

The longitudinal cross-sectional shape of the lenses 19 is any shape as long as light generated from a light emitting element 13 of a predetermined subpixel 101 and incident on a lens 19 can pass through a color filter 17 corresponding to the subpixel 101. In the example of Fig. 1, the longitudinal cross-sectional shape of the lenses 19 is a tongue piece shape with a curved end, but is not limited to this shape, and for example, as illustrated in Figs. 4A, 4B, 5A, 5B, 5C, and the like, the lenses 19 may have a longitudinal cross-sectional shape such as a semicircular shape, an elliptical shape, a trapezoidal shape, or a triangular shape. Note that the longitudinal cross-sectional shape of the lenses 19 indicates a cross-sectional shape recognized in a case where the lenses are cut along a plane in which the circumferential direction of the lenses 19 is a normal direction. Furthermore, the longitudinal cross-sectional shape of the lenses 19 may have a symmetrical shape as illustrated in Figs. 1, 4A, 4B, and the like, or may have an asymmetric shape as illustrated in Figs. 5A, 5B, and 5C. The symmetric shape here indicates a shape that is approximately line-symmetric in a case where a line parallel to the Z-axis direction is set as an axis. In a case where the longitudinal cross-sectional shape of the lenses 19 is an asymmetric shape, a shape in which the inclination on the outer side is steeper than the inclination on the inner side is preferable from the viewpoint of effectively reducing color mixture. Note that Fig. 4A illustrates a case where the longitudinal cross-sectional shape of the lenses 19 is an isosceles triangular shape. Fig. 4B illustrates a case where the longitudinal cross-sectional shape of the lenses 19 is an isosceles trapezoidal shape. Fig. 5A illustrates a case where the longitudinal cross-sectional shape of the lenses 19 is a triangular shape in which the lengths of two sides from the protruding end of a lens 19 toward the bottom surface of the lens 19 are different. Fig. 5B illustrates a case where the longitudinal cross-sectional shape of the lenses 19 is a non-isosceles trapezoidal shape. Fig. 5C illustrates a case where the longitudinal cross-sectional shape of the lenses 19 is a convex curved shape in which the degrees of curvature of curves from the protruding end of a lens 19 toward the bottom surface of the lens are different. Note that, for convenience of description, a filling resin layer 20 and the counter substrate 21 are omitted in the examples of Figs. 4A, 4B, 5A, 5B, and 5C.

### (Refractive Index of Lenses)

The refractive index of the lenses 19 is higher than the refractive index of the outer portions 190. As a result, light that travels from the inside to the outer portions 190 of the lenses 19 is easily totally reflected and refracted with the convex surface portions 19A of the lenses 19 as interfaces. Furthermore, light incident on a lens 19 of a predetermined subpixel 101 is refracted by the convex surface portion 19A of the lens 19, and can be made difficult to be directed to adjacent subpixels. In the example of Fig. 1, the refractive index of the lenses 19 is higher than the refractive index of the color filters 17.

### (Material of Lenses)

Examples of a material included in the lenses 19 include, for example, ultraviolet curable resin, thermosetting resin, and the likes, similarly to the flattening layer 16 and the like. Each of the lenses 19 preferably includes a photosensitive resin material. In this case, the lenses 19 are easily formed with high accuracy using a photolithography technology or the like. Furthermore, adhesion between the lenses 19 and the flattening layer 16 is easily improved.

Furthermore, each of the lenses 19 includes a material having optical transmissivity. Since each of the lenses 19 includes a material having optical transmissivity, light generated by the light emitting elements 13 more reliably travels in the lenses 19. Furthermore, the lenses 19 may be transparent or may be colored in accordance with the color types of the subpixels 101. In a case where the lenses 19 are arranged in the color filters 17, the uniformity of the color of light passing through the color filters 17 can be enhanced in the subpixels 101 by the lenses 19 being colored.

### (Filling Resin Layer)

The filling resin layer 20 may be formed on the first surface sides of the color filters 17. The filling resin layer 20 can exert a function of smoothing the surfaces of the first surfaces that are surfaces on which the color filters 17 are formed. Furthermore, the filling resin layer 20 can have a function as an adhesive layer for bonding the counter substrate 21 to be described below. Examples of the filling resin layer 20 include ultraviolet curable resin, thermosetting resin, and the like.

### (Counter Substrate)

The counter substrate 21 is provided on the filling resin layer 20 in a state of facing the drive substrate 11. The counter substrate 21 seals the light emitting elements 13 together with the filling resin layer 20. The counter substrate 21 may include a similar material to the substrate 11A included in the drive substrate 11, and preferably includes a material such as glass or the like.

### [1-2 Operation and Effect]

In a display device including light emitting elements including an organic layer and color filters, a part of light generated from a light emitting element of a predetermined subpixel travels toward color filters of adjacent subpixels, and color leakage to the adjacent subpixels or color mixture in a pixel may occur due to the color leakage. According to the display device 10 according to the first embodiment, the ring-shaped lenses 19 are arranged at the peripheral edge portions 102 of the subpixels 101 so that color filters 17 adjacent to the color filters 17 corresponding to the subpixels 101 are not entered in a plan view of the subpixels 101. Furthermore, the refractive index of the lenses 19 is higher than that of the outer portions 190. Therefore, even if a part of light L1 generated from a light emitting element 13 of a predetermined subpixel 101 travels in a direction toward color filters 17 of adjacent subpixels, the light L1 generates at least one of total reflection or refraction in the lens 19, and becomes light L2 that travels through the predetermined subpixel 101. Therefore, the amount of light L3 that travels to the adjacent subpixels as it is among the light L1 can be reduced. Thus, according to the first embodiment, so-called color leakage in which light generated in a light emitting element 13 corresponding to a predetermined subpixel 101 enters adjacent subpixels can be reduced. Then, light extraction efficiency of the light generated from the light emitting element 13 of the predetermined subpixel 101 can be improved.

### [1-3 Modification of Display Device]

In the display device 10 of the first embodiment, the layout of the subpixels 101R, 101G, and 101B is not limited to the example of Fig. 1, and may be, for example, a delta-shaped layout as illustrated in Fig. 3A or square arrangement as illustrated in Fig. 3B. In this case, the color filters 17 (red filter 17R, green filter 17G, and blue filter 17B) are also preferably laid out in accordance with the subpixels 101. For example, in a case where the subpixels 101 are arranged in a delta shape, the color filters 17 are also arranged in a delta shape. Note that, as for the size of the subpixels 101 and the size of the color filters 17, the size of the subpixels 101 and the size of the color filters 17 may be substantially the same as illustrated in the examples of Figs. 3A and 3B, or the size of the color filters 17 may be larger than the size of the subpixels 101. Note that the delta shape indicates arrangement in which the centers of the three subpixels 101R, 101G, and 101B are arranged to form a triangle if the centers are connected. The square arrangement indicates arrangement in which the centers of four subpixels (subpixels 101R, 101G, 101B, and 101B in the example of Fig. 3B) are arranged to form a square if the centers are connected.

### [2 Second Embodiment]

### [2-1 Configuration of Display Device]

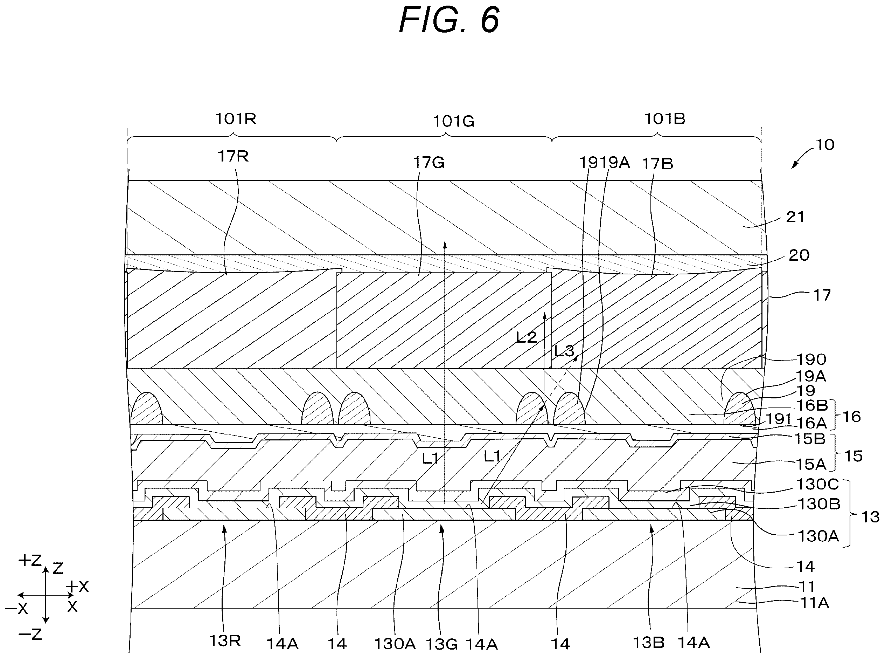

A display device 10 according to a second embodiment will be described. As illustrated in Fig. 6, the display device 10 according to the second embodiment includes a drive substrate 11, a plurality of light emitting elements 13, a protective layer 15, and a plurality of color filters 17 similarly to the first embodiment, and further includes ring-shaped lenses 19. Furthermore, also in the display device 10 according to the second embodiment, a plurality of subpixels 101 is determined corresponding to the plurality of respective light emitting elements 13 similarly to the first embodiment.

The drive substrate 11, the plurality of light emitting elements 13, and the protective layer 15 may be similar to those in the first embodiment. The plurality of color filters 17 is formed similarly to the first embodiment except that the lenses 19 are not necessarily arranged. However, this does not restrict the lenses 19 being further provided in the color filters 17 in the second embodiment. In the second embodiment, the lenses 19 may be provided in each of a flattening layer 16 to be described below and the color filters 17.

### (Flattening Layer)

In the display device 10 according to the second embodiment, the flattening layer 16 is formed between the protective layer 15 and the color filters 17. In the example of Fig. 6, the flattening layer 16 includes a first flattening layer 16A and a second flattening layer 16B laminated on the first flattening layer 16A. In the flattening layer 16, the second surface (lower surface) of the first flattening layer 16A faces the protective layer 15, and the first surface (upper surface) of the second flattening layer 16B faces the color filters 17. The refractive index of the second flattening layer 16B is higher than the refractive index of the first flattening layer 16A.

As described above, selecting a material having a higher refractive index in the second flattening layer 16B than in the first flattening layer 16A is preferable, although the material of the first flattening layer 16A and the material of the second flattening layer 16B are not particularly limited thereto. In this case, since the refractive index of the second flattening layer 16B is higher than that of the first flattening layer 16A, light easily travels from the first flattening layer 16A toward the second flattening layer 16B.

### (Lenses)

In the display device 10 according to the second embodiment, the lenses 19 are provided in the flattening layer 16 so that the flattening layer 16 serves as outer portions 190. Bottom surfaces 191 of the lenses 19 are arranged on the first surface of the first flattening layer 16A.

Furthermore, the outer portions 190 of the lenses are the second flattening layer 16B, and the refractive index of the lenses 19 is higher than that of the second flattening layer 16B. Therefore, in the second embodiment, light from the inside of the lenses 19 toward the second flattening layer 16B serving as the outer portions 190 generates at least one of total reflection or refraction with convex surface portions 19A of the lenses 19 as interfaces. As a result, light leakage to adjacent subpixels can be reduced. Note that the lenses 19 are similar to those of the first embodiment other than those points. For example, the shape of the lenses 19 and the arrangement of the lenses 19 in a plan view of the subpixels 101 are also similar to those of the first embodiment.

### [2-2 Operation and Effect]

In the display device 10 according to the second embodiment, the ring-shaped lenses 19 are provided similarly to the first embodiment. Furthermore, the positions where the lenses 19 are arranged are positions where the convex surface portions 19A exist in the second flattening layer 16B having a refractive index lower than the refractive index of the lenses 19. As a result, according to the display device 10, as illustrated in Fig. 6, among light generated in a light emitting element 13 corresponding to a predetermined subpixel 101, light directed to adjacent subpixels generates at least one of total reflection or refraction in a lens 19, and light can travel through the predetermined subpixel. For example, in a case where light directed to a blue subpixel 101B that is an adjacent subpixel among light L1 generated in a light emitting element 13G corresponding to a green subpixel 101G travels into a lens 19, the light L1 generates at least one of total reflection or refraction at a convex surface portion 19A of the lens 19, and becomes light L2 that travels in the subpixel 101G. As a result, light L3 directed to the blue subpixel 101B among the light L1 can be reduced, and light leakage can be reduced. Thus, according to the second embodiment, so-called color leakage in which light generated in a light emitting element 13 corresponding to a predetermined subpixel 101 enters adjacent subpixels can be reduced, and occurrence of color mixture in a pixel due to the color leakage can be reduced.

### [3 Third Embodiment]

### [3-1 Configuration of Display Device]

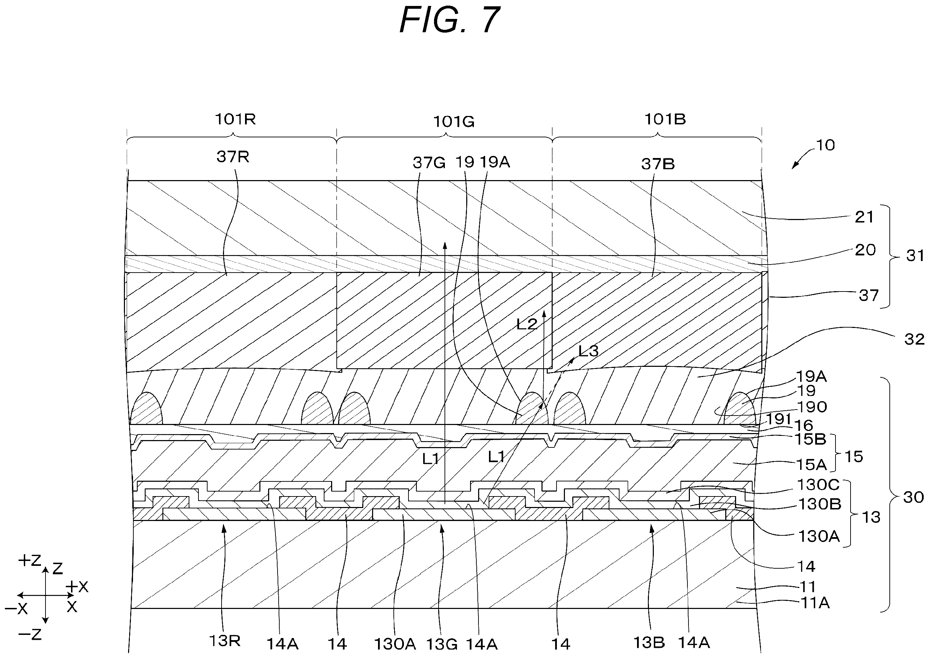

A display device 10 according to a third embodiment will be described. As illustrated in Fig. 7, the display device 10 according to the third embodiment includes a first substrate 30 and a second substrate 31, and a sealing resin layer 32 that joins the first substrate 30 and the second substrate 31.

### (First Substrate)

The first substrate 30 includes a drive substrate 11, light emitting elements 13 arranged on the drive substrate 11, and a protective layer 15. The drive substrate 11, the light emitting elements 13, and the protective layer 15 in the display device 10 according to the third embodiment may be similar to those in the first embodiment.

In the display device 10, a plurality of subpixels 101 corresponding to a plurality of respective light emitting elements 13 is formed similarly to the first embodiment.

### (Flattening Layer)

In the first substrate 30, a flattening layer 16 is preferably provided on the protective layer 15. Since the flattening layer 16 is provided, lenses 19 can be accurately arranged on the first substrate 30. The flattening layer 16 can be formed in a similar manner as in the first embodiment.

### (Second Substrate)

The second substrate 31 includes a counter substrate 21 and a plurality of color filters 37. The counter substrate 21 may be similar to that of the first embodiment.

### (Color Filters)

The plurality of color filters 37 may be formed similarly to the color filters 17 of the first embodiment except that the color filters are provided on the second surface side (lower side, -Z direction side) of the second substrate 31 (Fig. 7). In the example of Fig. 7, for example, a red color filter (red filter 37R), a green color filter (green filter 37G), and a blue color filter (blue filter 37B) are arranged as the plurality of color filters 37 similarly to the first embodiment. The red filter 37R, the green filter 37G, and the blue filter 37B are provided so as to face a light emitting element 13R for a red subpixel, a light emitting element 13G for a green subpixel, and a light emitting element 13B for a blue subpixel, respectively, similarly to the first embodiment. In the example of Fig. 7, the arrangement of the color filters 37 is arrangement in which the red filter 37R, the green filter 37G, and the blue filter 37B are repeatedly arranged in this order.

As illustrated in Fig. 7, a filling resin layer 20 may be formed between the counter substrate 21 and the color filters 37 similarly to the first embodiment. However, this does not prohibit the color filters 37 from being formed on the surface of the counter substrate 21 without the filling resin layer 20 interposed therebetween.

### (Sealing Resin Layer)

The sealing resin layer 32 joins the protective layer 15 of the first substrate 30 and the color filters 37 of the second substrate 31 to each other. At this time, the light emitting elements 13 of the first substrate and the color filters of the second substrate are aligned with each other. The alignment can be implemented by the first substrate 30 being faced to the second substrate 31 such that the red filter 37R corresponds to the light emitting element 13R, the green filter 37G corresponds to the light emitting element 13G, and the blue filter 37B corresponds to the light emitting element 13B.

The material of the sealing resin layer 32 is any material as long as light generated in the light emitting elements 13 can be transmitted toward the color filters 37, and may include a similar material to the flattening layer 16 described in the first embodiment.

### (Lenses)

In the display device 10 according to the third embodiment, the lenses 19 are provided in peripheral edge portions 102 of the subpixels 101 similarly to the first embodiment and the second embodiment.

However, in the third embodiment, as illustrated in Fig. 7, the lenses 19 are provided in the sealing resin layer 32 so that the sealing resin layer 32 serves as outer portions 190. Furthermore, each of the lenses 19 is provided on the first substrate and includes a convex surface portion 19A that is a convex in a direction away from the first substrate 30. The lenses 19 are similar to those of the first embodiment other than those points. For example, the arrangement of the lenses 19 in a plan view of the subpixels 101 is also similar to that of the first embodiment. That is, each of the lenses 19 is provided at a position from which a position across adjacent color filters 37 is excluded in a plan view of the subpixels 101. For example, a lens 19 provided in a subpixel 101G is formed so as not to enter the formation portions of color filters (red filter 37R, blue filter 37B) of subpixels 101R and 101B that are adjacent subpixels to the subpixel 101G.

In the display device 10 according to the third embodiment, the sealing resin layer 32 is the outer portions 190 of the lenses 19, and the refractive index of the lenses 19 is higher than the refractive index of the sealing resin layer 32. Therefore, in the third embodiment, light from the inside of the lenses 19 toward the sealing resin layer 32 serving as the outer portions 190 generates at least one of total reflection or refraction with convex surface portions 19A of the lenses 19 as interfaces, and light leakage to adjacent subpixels is reduced.

Note that bottom surfaces 191 of the lenses 19 are preferably located on the first surface of the flattening layer 16 similarly to the first embodiment.

### [3-2 Operation and Effect]

In the display device 10 according to the third embodiment, the ring-shaped lenses are provided similarly to the first embodiment. Furthermore, the positions where the lenses 19 are arranged are positions where convex surface portions 19A exist in the sealing resin layer 32 having a refractive index lower than the refractive index of the lenses 19. As a result, according to the display device 10, among light L1 generated in a light emitting element 13 corresponding to a predetermined subpixel 101, light L3 that travels to an adjacent subpixel can be reduced, and the amount of light L2 that travels through the predetermined subpixel 101 can be increased similarly to the first embodiment and the second embodiment. Therefore, according to the display device 10 according to the third embodiment, light leakage to adjacent subpixels can be reduced, and color mixture of a pixel can be reduced.

### [4 Fourth Embodiment]

### [4-1 Configuration of Display Device]

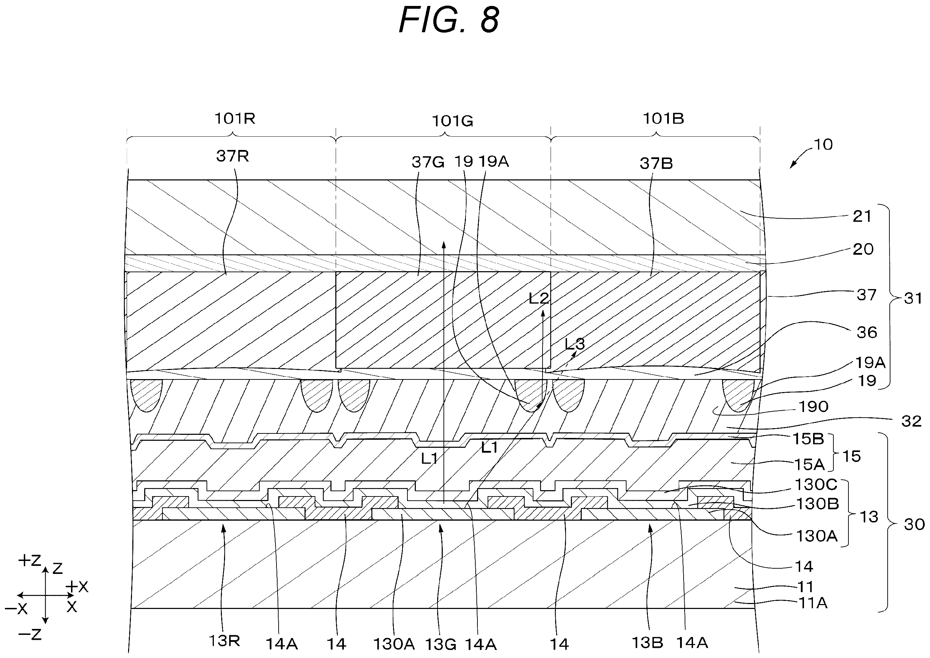

A display device 10 according to a fourth embodiment will be described. As illustrated in Fig. 8, the display device 10 according to the fourth embodiment is formed similarly to the third embodiment except that lenses 19 are arranged on a second surface side of a second substrate 31 instead of arranging the lenses 19 on a first surface side of a first substrate 30.

In this display device 10, each of the lenses 19 is provided on the second substrate 31 and includes a convex surface portion 19A that is a convex in a direction away from the second substrate 31. The lenses 19 are provided in a sealing resin layer 32 so that the sealing resin layer 32 serves as outer portions 190. Surfaces corresponding to bottom surfaces 191 of the lenses 19 in the third embodiment are located on the second surface side of the second substrate 31 in the fourth embodiment. Furthermore, in the example of Fig. 8, a flattening layer 36 is formed on second surface sides of color filters 37, and the lenses 19 are formed on the second surface side of the flattening layer 36 in the second substrate 31. This facilitates accurate formation of the lenses 19 on the second surface side of the second substrate 31. The flattening layer 36 may be formed using a similar material to that of the flattening layer 16 of the first embodiment.

### [4-2 Operation and Effect]

According to the display device 10 according to the fourth embodiment, the ring-shaped lenses 19 are provided in subpixels 101. Furthermore, the positions where the lenses 19 are arranged are positions where convex surface portions 19A exist in the sealing resin layer 32 having a refractive index lower than the refractive index of the lenses 19. As a result, according to the display device 10, among light L1 generated in a light emitting element corresponding to a predetermined subpixel 101, light directed to an adjacent subpixel generates at least one of total reflection or refraction in a lens 19, the amount of light L3 that enters the adjacent subpixel is reduced, and light L2 that travels in the predetermined subpixel 101 increases. Thus, according to the display device 10 according to the fourth embodiment, light leakage to adjacent subpixels can be reduced.

### [5 Fifth Embodiment]

### [5-1 Configuration of Display Device]

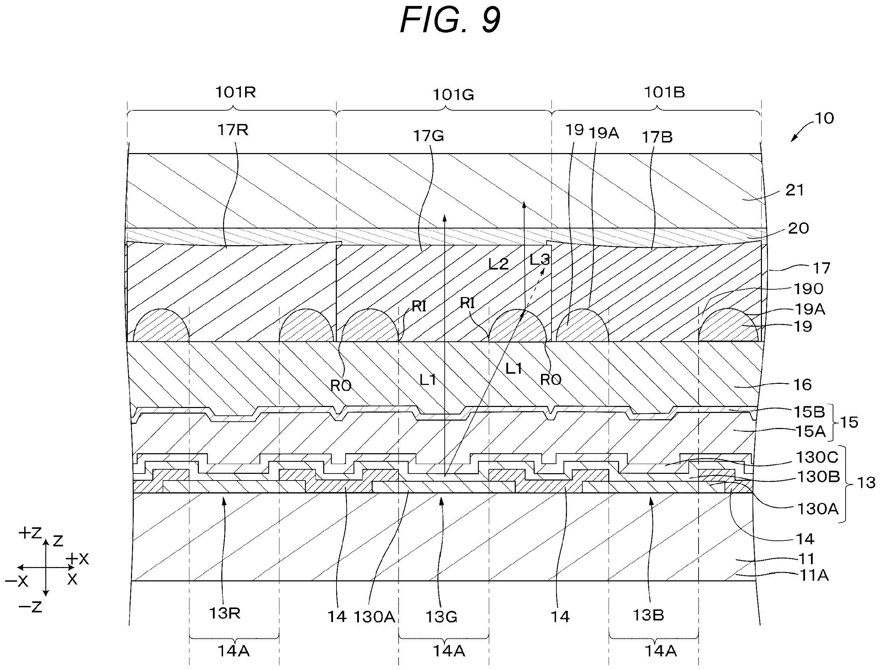

In the display device 10 of the first to fourth embodiments described above, as illustrated in Fig. 9, each of lenses 19 is preferably provided at a position from which a position overlapping an opening 14A is excluded in a plan view of subpixels 101 (fifth embodiment). Fig. 9 illustrates an example in which each of the lenses 19 is provided at a position from which a position overlapping the opening 14A is excluded in the display device 10 according to the first embodiment. Here, the description will be continued on the basis of this example.

In a display device 10 of the fifth embodiment, as described in the first embodiment, a plurality of first electrodes 130A is formed in a state of being separated from each other for every subpixel 101, and an insulating layer 14 is formed between the adjacent first electrodes 130A. Furthermore, the insulating layer 14 includes a plurality of openings 14A, and each of the openings 14A is arranged on the respective first electrodes 130A.

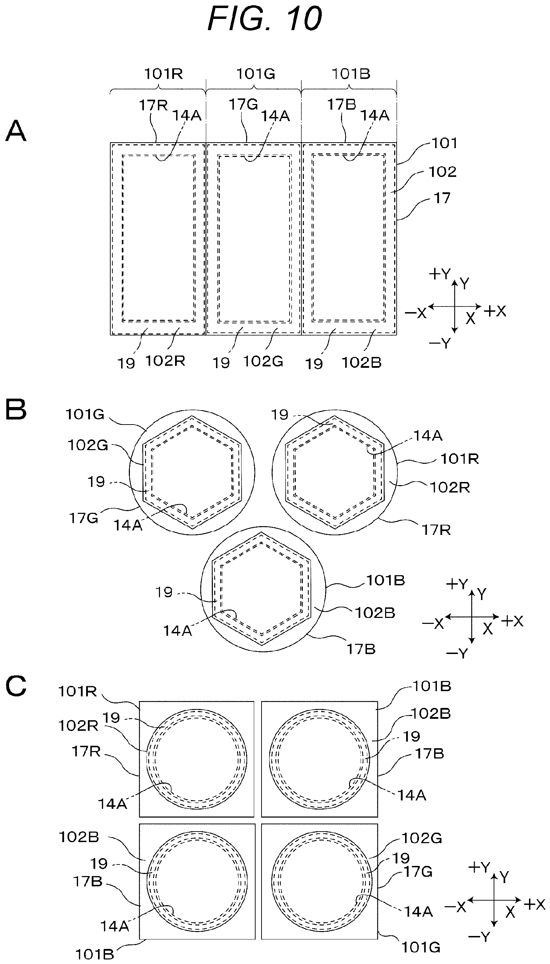

In the fifth embodiment, as illustrated in Figs. 9 and 10A, since each of the lenses 19 is provided at a position from which a position overlapping the opening 14A is excluded in a plan view of the subpixels 101, each of the lenses 19 is provided so as not to enter a portion immediately above the opening 14A. Fig. 10A is a plan view for describing the arrangement of the subpixels 101, the openings 14A, and the lenses 19 in the display device 10 of Fig. 9.

As illustrated in Figs. 9 and 10A, the size of the openings 14A is generally formed to be slightly smaller than the size of color filters 17 so as to be inside the formation areas of the color filters 17. In consideration of this point, a ring-shaped lens 19 provided at a peripheral edge portion 102 of a predetermined subpixel 101 is preferably formed inside the color filter 17 and outside the opening 14A. That is, in a subpixel 101, an inner peripheral edge RI of the lens 19 preferably does not enter a portion immediately above the opening 14A, and an outer peripheral edge RO of the lens 19 is located inside the edge of the color filter 17. In this case, the lens 19 is arranged in a portion inside the color filter 17 and outside the opening 14A in the peripheral edge portion 102 of the subpixel 101.

In the display device 10 according to the fifth embodiment, each of the lenses 19 is preferably provided outside the opening 14A along the peripheral edge of the opening 14A in a plan view of the subpixels 101 since the traveling direction of light that travels in a direction toward adjacent subpixels can be efficiently changed. For example, in the example of Fig. 9, an inner peripheral end R1 of a ring-shaped lens 19 provided in a peripheral edge portion 102G of a green subpixel 101G is formed along a peripheral edge of an opening 14A so as not to enter a portion immediately above the opening 14A. Furthermore, an outer peripheral edge RO of the lens 19 is formed inside an outer peripheral end of a color filter 17 (green filter 17G) so as not to enter the formation portions of color filters 17 corresponding to subpixels 101R and 101B (red filter 17R, blue filter 17B) that are adjacent subpixels to the subpixel 101G. This similarly applies to both a ring-shaped lens 19 provided in a peripheral edge portion 102R of the red subpixel 101R and a ring-shaped lens 19 provided in a peripheral edge portion 102B of the blue subpixel 101B.

Note that, in a plan view of the subpixels 101, the openings 14A may have a shape matching the shape of the color filters 17 as illustrated in the examples of Figs. 9 and 10A, or may not match the shape of the color filters 17 as illustrated in Figs. 10B and 10C. Fig. 10B illustrates an example in which the color filters 17 have a circular shape, the openings 14A have a hexagonal shape, and each of the ring-shaped lenses 19 is formed in a portion outside an opening 14A along the peripheral edge of the opening 14A in the peripheral edge portion 102 of the subpixel 101. Fig. 10C illustrates an example in which the color filters 17 have a substantially rectangular shape, the openings 14A have a circular shape, and each of the ring-shaped lenses 19 is formed in a portion outside an opening 14A along the peripheral edge of the opening 14A in the peripheral edge portion 102 of the subpixel 101. In either case of Figs. 10B and 10C, the shape is a shape that does not enter adjacent subpixels.

### [5-2 Operation and Effect]

In the display device 10 according to the fifth embodiment, each of the ring-shaped lenses 19 is provided outside an opening 14A of the lens 19 in a plan view of the subpixels 101 so as not to enter immediately above the opening 14A. As a result, light that travels from a light emitting element 13 in a predetermined subpixel 101 in a direction immediately above an opening 14A is directly emitted from a display surface 10A through a color filter 17. Furthermore, as for light that travels in an oblique direction from a light emitting element 13, the amount of light that passes through a lens 19 is easily increased. Therefore, among light L1 generated in a light emitting element 13 corresponding to a predetermined subpixel 101, causing light directed to an adjacent subpixel to be light L2 that travels in the predetermined subpixel 101 is efficiently implemented, and the amount of light L3 that enters the adjacent subpixel as it is can be reduced.

### [6 Sixth Embodiment]

### [6-1 Configuration of Display Device]

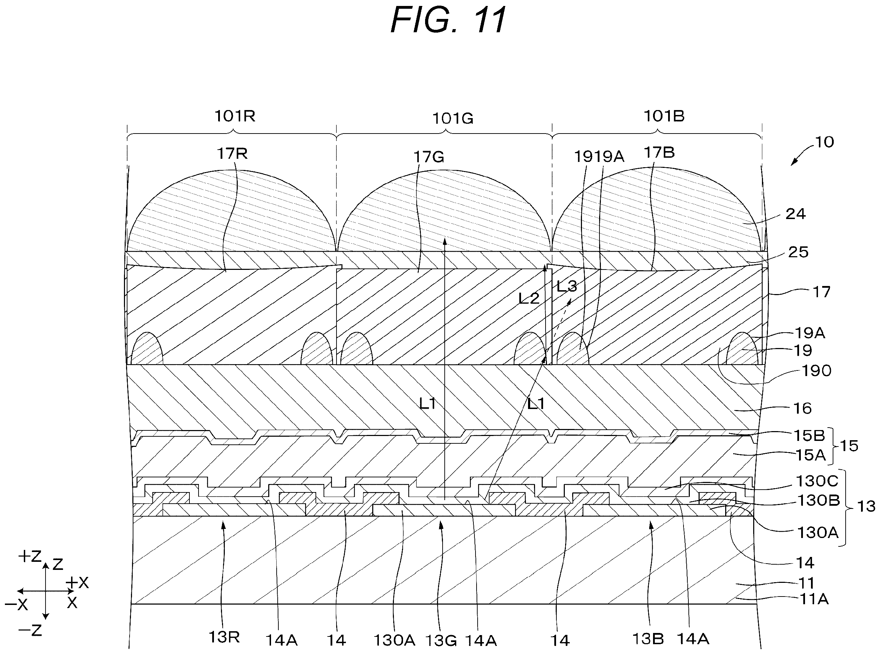

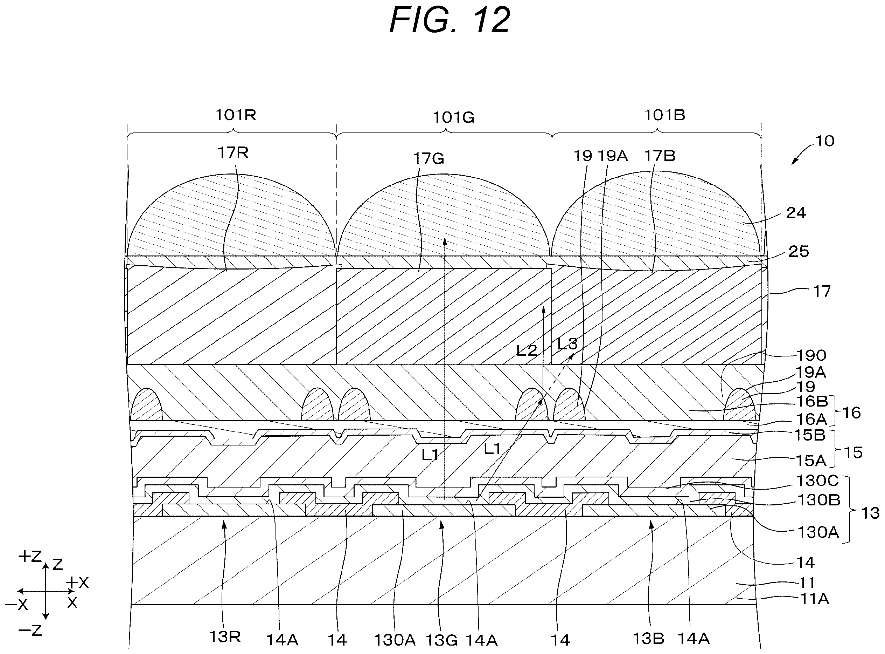

In the display device 10 of the first embodiment and the second embodiment described above, and in an embodiment including the configuration of the display device 10 of the first embodiment or the second embodiment of the fifth embodiment, for example, as illustrated in Figs. 11 and 12, convex lenses 24 may be further provided on the first surface sides of color filters 17 (sixth embodiment). In a display device 10 illustrated in the examples of Figs. 11 and 12, the convex lenses 24 are formed on the first surfaces of a plurality of respective color filters 17. Fig. 11 illustrates an example in which the convex lenses 24 are formed in the display device 10 according to the first embodiment. Fig. 12 illustrates an example in which the convex lenses 24 are formed in the display device 10 according to the second embodiment. Note that, for convenience of description, a filling resin layer 20 and a counter substrate 21 are omitted in the examples of Figs. 11 and 12.

### (Convex Lenses)

Unlike the lenses 19, each of the convex lenses 24 is formed in a non-ring shape and is a single-sided convex lens. Examples of each of the convex lenses 24 include an on-chip microlens and the like. Each of the convex lenses 24 can be formed by an on-chip microlens (OCL) forming method using a melting method, an etch-back method, or the like being applied. Each of the convex lenses 24 may include a similar material to the ring-shaped lenses 19 described in the first embodiment.

Note that, in the examples of Figs. 11 and 12, a cover layer 25 that covers the color filters 17 is formed on proximal end sides of the convex lenses 24 (between the convex lenses 24 and the color filters 17). A material similar to a material included in the convex lenses 24 may be used for the cover layer 25. In a case where the cover layer 25 is formed on the color filters 17, exposure of the color filters 17 can be effectively eliminated.

### [6-2 Operation and Effect]

According to the display device 10 according to the sixth embodiment, the traveling direction of light that travels toward an adjacent subpixel among light L1 generated in a light emitting element 13 corresponding to a predetermined subpixel 101 can be changed to light L2 that travels through the predetermined subpixel by the lens 19, and the amount of light L3 that travels toward the adjacent subpixel can be reduced, similarly to the first embodiment and the second embodiment. As a result, light leakage to adjacent subpixels can be reduced. Moreover, according to the sixth embodiment, since the convex lenses 24 are provided, the direction of light emitted from a display surface 10A side is easily adjusted.

### [7 Seventh Embodiment]

### [7-1 Configuration of Display Device]

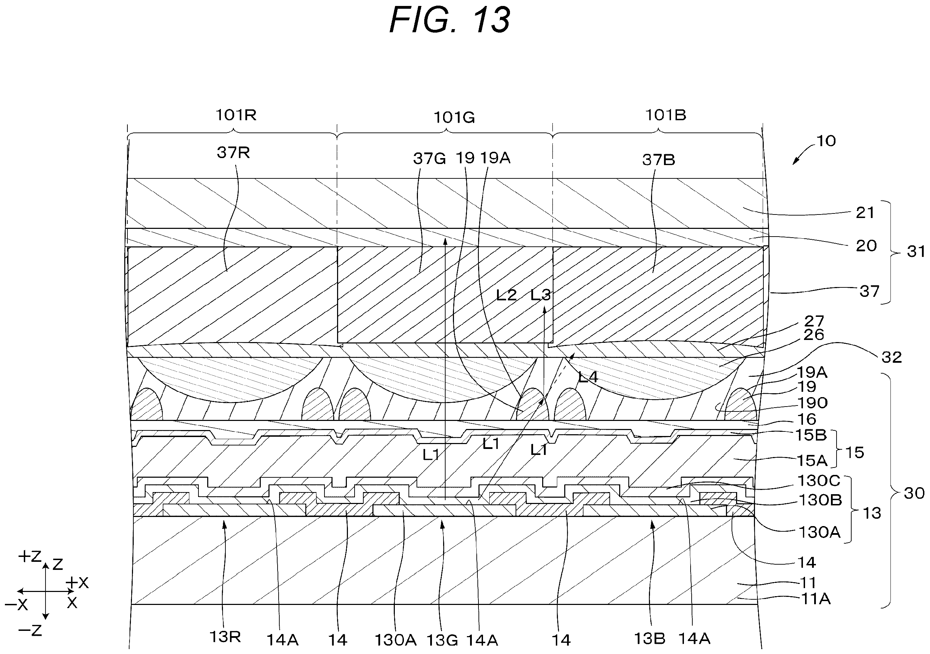

In the display device 10 of the third embodiment described above, and in an embodiment including the configuration of the display device 10 of the third embodiment of the fifth embodiment, as illustrated in Fig. 13, convex lenses 26 may be further provided on the second surface sides of color filters 37 (seventh embodiment). In a display device 10 illustrated in the example of Fig. 13, the convex lenses 26 are formed on the second surface sides of a plurality of respective color filters 37. Each of the convex lenses 26 may be formed using a material and a forming method similar to those of the convex lenses 24 described in the sixth embodiment. Furthermore, in the display device 10 according to the seventh embodiment, as described in the sixth embodiment, a cover layer 27 that covers the color filters 37 may be formed between the convex lenses 26 and the color filters 37. The cover layer 27 may be formed in a similar manner to the cover layer 25 formed between the convex lenses 24 and the color filters 17 described in the sixth embodiment.

### [7-2 Operation and Effect]

According to the display device 10 according to the seventh embodiment, the traveling direction of light that travels toward an adjacent subpixel among light L1 generated in a light emitting element 13 corresponding to a predetermined subpixel 101 can be changed to light L2 that travels through the predetermined subpixel by the lens 19, and the amount of light L3 that travels toward the adjacent subpixel can be reduced, similarly to the sixth embodiment. Moreover, according to the seventh embodiment, since the convex lenses 26 are provided, the direction of light emitted from a display surface 10A side is easily adjusted.

### [8 Application Examples]

### (Electronic Device)

A display device 10 according to one of the above-described embodiments may be provided in various electronic devices. Especially, this is preferably provided in an electronic viewfinder of a video camera or a single-lens reflex camera, a head mounted display, or the like in which high resolution is required, used for enlarging near the eyes.

### (Specific Example 1)

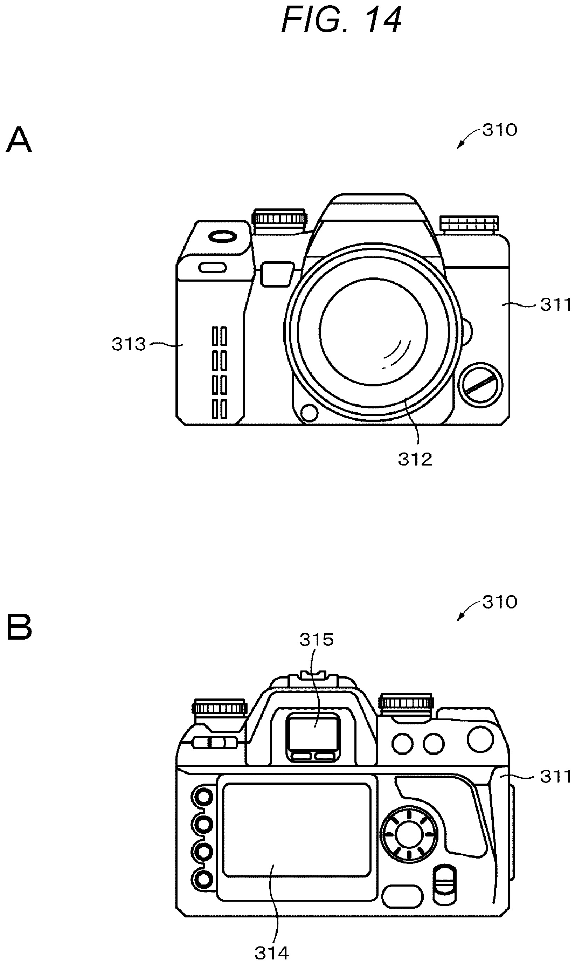

Fig. 14A is a front view illustrating an example of an external appearance of a digital still camera 310. Fig. 14B is a rear view illustrating an example of an external appearance of the digital still camera 310. The digital still camera 310 is of a lens interchangeable single lens reflex type, and includes an interchangeable imaging lens unit (interchangeable lens) 312 substantially at the center in front of a camera main body portion (camera body) 311, and a grip portion 313 to be held by a photographer on a front left side.

A monitor 314 is provided at a position shifted to the left from the center of a rear surface of the camera main body portion 311. An electronic viewfinder (eyepiece window) 315 is provided above the monitor 314. By looking through the electronic viewfinder 315, the photographer can visually confirm a light image of the subject guided from the imaging lens unit 312 and determine a picture composition. As the electronic viewfinder 315, any display device 10 according to one of the above-described embodiments and modifications thereof may be used.

### (Specific Example 2)

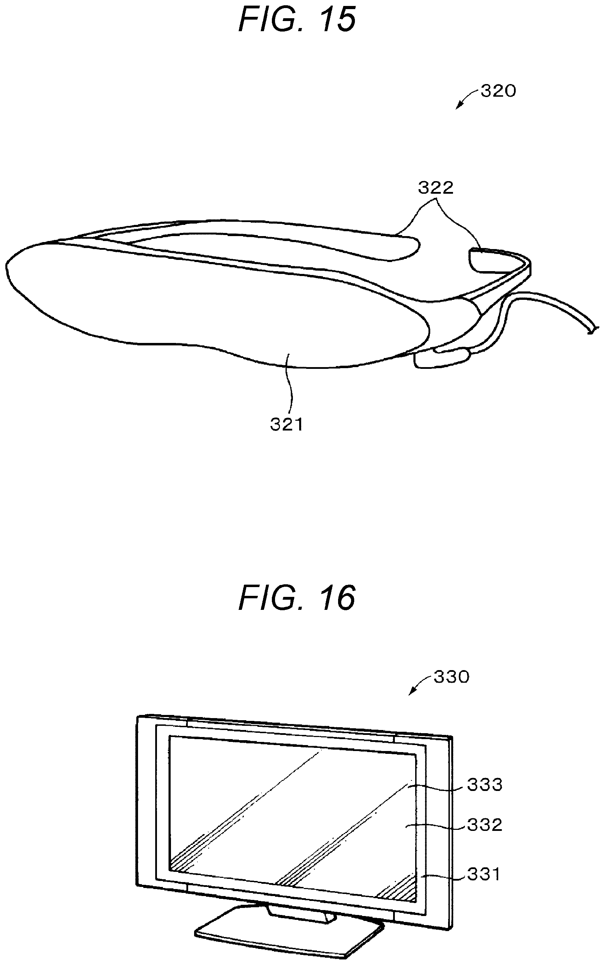

Fig. 15 is a perspective view illustrating an example of an external appearance of a head mounted display 320. The head mounted display 320 includes, for example, ear hooking portions 322 to be worn on the head of the user on both sides of a glass-shaped display unit 321. As the display unit 321, any display device 10 according to one of the above-described embodiments and modifications thereof may be used.

### (Specific Example 3)

Fig. 16 is a perspective view illustrating an example of an external appearance of a television device 330. The television device 330 includes, for example, a video display screen unit 331 including a front panel 332 and a filter glass 333, and the video display screen unit 331 includes any display device 10 according to one of the above-described embodiments and modifications thereof.

Although the display devices and the application examples according to the first to seventh embodiments and each modification of the present disclosure have been specifically described above, the present disclosure is not limited to the display devices and the application examples according to the first to seventh embodiments and each modification described above, and various modifications based on the technical idea of the present disclosure are possible.

For example, the configurations, methods, steps, shapes, materials, numerical values, and the like given in the display devices and the application examples according to the first to seventh embodiments and each modification are merely examples, and different configurations, methods, steps, shapes, materials, numerical values, and the like may be used as necessary.

The configurations, methods, steps, shapes, materials, numerical values, and the like of the display devices and the application examples according to the first to seventh embodiments and each modification can be combined with each other without departing from the gist of the present disclosure.

The materials exemplified in the display devices and the application examples according to the first to seventh embodiments and each modification can be used alone or in combination of two or more unless otherwise specified.

Furthermore, the present disclosure can also adopt the following configurations.
(1) A display device including
   a substrate,
   a plurality of light emitting elements arranged two-dimensionally on the substrate and including a plurality of first electrodes, an organic layer arranged on the plurality of first electrodes, and a second electrode that covers the organic layer,
   a protective layer that covers the plurality of light emitting elements, and
   a plurality of color filters provided on an upper side of the protective layer,
   in which a plurality of subpixels corresponding to the plurality of respective light emitting elements is formed,
   a ring-shaped lens including a convex surface portion that is convex in a direction away from the substrate is provided in a peripheral edge portion of each of the subpixels at a position from which a position across the color filters of an adjacent subpixel adjacent to each of the subpixels is excluded in a plan view of the subpixels, and
   a refractive index of the lens is higher than a refractive index of an outer portion of the lens in contact with the convex surface portion.
(2) The display device according to (1) described above,
   in which the lens is provided in the color filters so that the color filters serve as the outer portion.
(3) The display device according to (2) described above,
   in which a flattening layer is further formed between the protective layer and the color filters, and
   a bottom surface of the lens is in contact with the flattening layer.
(4) The display device according to (1) described above,
   in which a flattening layer is further formed between the protective layer and the color filters, and
   the lens is provided in the flattening layer so that the flattening layer serves as the outer portion.
(5) The display device according to (1) described above,
   in which a flattening layer is further formed between the protective layer and the color filters,
   the flattening layer includes a first flattening layer and a second flattening layer laminated on the first flattening layer and having a higher refractive index than the first flattening layer,
   the lens is provided on the first flattening layer, and
   the outer portion is the second flattening layer.
(6) A display device including
   a first substrate including a drive substrate, a plurality of light emitting elements arranged two-dimensionally on the drive substrate and including a plurality of first electrodes, an organic layer arranged on the plurality of first electrodes, and a second electrode that covers the organic layer, and a protective layer that covers the plurality of light emitting elements,
   a second substrate including a counter substrate arranged so as to face the drive substrate and a plurality of the color filters formed on the counter substrate, and
   a sealing resin layer that joins the protective layer of the first substrate and the color filters of the second substrate to each other,
   in which a plurality of subpixels corresponding to the plurality of respective light emitting elements is formed,
   a ring-shaped lens including a convex surface portion that is convex in a direction away from the first substrate is provided in a peripheral edge portion of each of the subpixels at a position from which a position across the color filters of an adjacent subpixel adjacent to each of the subpixels is excluded in a plan view of the subpixels, and
   a refractive index of the lens is higher than a refractive index of an outer portion of the lens in contact with the convex surface portion.
(7) A display device including
   a first substrate including a drive substrate, a plurality of light emitting elements arranged two-dimensionally on the drive substrate and including a plurality of first electrodes, an organic layer arranged on the plurality of first electrodes, and a second electrode that covers the organic layer, and a protective layer that covers the plurality of light emitting elements,
   a second substrate including a counter substrate arranged so as to face the drive substrate and a plurality of the color filters formed on the counter substrate, and
   a sealing resin layer that joins the protective layer of the first substrate and the color filters of the second substrate to each other,
   in which a plurality of subpixels corresponding to the plurality of respective light emitting elements is formed,
   a ring-shaped lens including a convex surface portion that is convex in a direction away from the second substrate is provided in a peripheral edge portion of each of the subpixels at a position from which a position across the color filters of an adjacent subpixel adjacent to each of the subpixels is excluded in a plan view of the subpixels, and
   a refractive index of the lens is higher than a refractive index of an outer portion of the lens in contact with the convex surface portion.
(8) The display device according to (1) described above,
   in which a plurality of the first electrodes is formed in a state of being separated from each other according to arrangement of the subpixels,
   an insulating layer is formed between the first electrodes adjacent to each other,
   the insulating layer includes a plurality of openings,
   each of the openings is arranged on a plurality of the respective first electrodes, and
   the lens is provided at a position from which a position overlapping with the openings is excluded in a plan view of the subpixels.
(9) The display device according to (8) described above,
   in which the lens is provided along a peripheral edge of the openings in a plan view of the subpixels.
(10) The display device according to any one of (1) to (9) described above,
   in which the lens has a semicircular, semi-elliptical, trapezoidal, or triangular longitudinal cross-sectional shape.
(11) The display device according to any one of (1) to (10) described above,
   in which the lens includes a material having optical transmissivity.
(12) The display device according to any one of (1) to (11) described above,
   in which the lens includes a photosensitive resin material.
(13) The display device according to any one of (1) to (6) and (8) to (12) described above,
   in which a convex lens is further provided on the color filters.
(14) An electronic device including the display device according to any one of (1) to (13) described above.

### REFERENCE SIGNS LIST

- 10: Display device
- 11: Drive substrate
- 11A: Substrate
- 13: Light emitting element
- 14: Insulating layer
- 14A: Opening
- 15: Protective layer
- 15A: First protective layer
- 15B: Second protective layer
- 16: Flattening layer
- 16A: First flattening layer
- 16B: Second flattening layer
- 17: Color filter
- 19: Lens
- 19A: Convex surface portion
- 20: Filling resin layer
- 21: Counter substrate
- 24: Convex lens
- 25: Cover layer
- 26: Convex lens
- 27: Cover layer
- 30: First substrate
- 31: Second substrate
- 32: Sealing resin layer
- 37: Color filter
- 101: Subpixel
- 102: Peripheral edge portion
- 130A: First electrode
- 130B: Organic layer
- 130C: Second electrode
- 190: Outer portion
- 191: Bottom surface
- 310: Digital still camera
- 311: Camera main body portion
- 312: Imaging lens unit
- 313: Grip portion
- 314: Monitor
- 315: Electronic viewfinder
- 320: Head mounted display
- 321: Display unit
- 322: Ear hooking portion
- 330: Television Device
- 331: Video display screen unit
- 332: Front panel
- 333: Filter glass

## Claims

1. A display device comprising:
a substrate;
a plurality of light emitting elements arranged two-dimensionally on the substrate and including a plurality of first electrodes, an organic layer arranged on the plurality of first electrodes, and a second electrode that covers the organic layer;
a protective layer that covers the plurality of light emitting elements; and
a plurality of color filters provided on an upper side of the protective layer,
wherein a plurality of subpixels corresponding to the plurality of respective light emitting elements is formed,
a ring-shaped lens including a convex surface portion that is convex in a direction away from the substrate is provided in a peripheral edge portion of each of the subpixels at a position from which a position across the color filters of an adjacent subpixel adjacent to each of the subpixels is excluded in a plan view of the subpixels, and
a refractive index of the lens is higher than a refractive index of an outer portion of the lens in contact with the convex surface portion.

2. The display device according to claim 1,
wherein the lens is provided in the color filters so that the color filters serve as the outer portion.

3. The display device according to claim 2,
wherein a flattening layer is further formed between the protective layer and the color filters, and
a bottom surface of the lens is in contact with the flattening layer.

4. The display device according to claim 1,
wherein a flattening layer is further formed between the protective layer and the color filters, and
the lens is provided in the flattening layer so that the flattening layer serves as the outer portion.

5. The display device according to claim 1,
wherein a flattening layer is further formed between the protective layer and the color filters,
the flattening layer includes a first flattening layer and a second flattening layer laminated on the first flattening layer and having a higher refractive index than the first flattening layer,
the lens is provided on the first flattening layer, and
the outer portion is the second flattening layer.

6. A display device comprising:
a first substrate including a drive substrate, a plurality of light emitting elements arranged two-dimensionally on the drive substrate and including a plurality of first electrodes, an organic layer arranged on the plurality of first electrodes, and a second electrode that covers the organic layer, and a protective layer that covers the plurality of light emitting elements;
a second substrate including a counter substrate arranged so as to face the drive substrate and a plurality of color filters formed on the counter substrate; and
a sealing resin layer that joins the protective layer of the first substrate and the color filters of the second substrate to each other,
wherein a plurality of subpixels corresponding to the plurality of respective light emitting elements is formed,
a ring-shaped lens including a convex surface portion that is convex in a direction away from the first substrate is provided in a peripheral edge portion of each of the subpixels at a position from which a position across the color filters of an adjacent subpixel adjacent to each of the subpixels is excluded in a plan view of the subpixels, and
a refractive index of the lens is higher than a refractive index of an outer portion of the lens in contact with the convex surface portion.

7. A display device comprising:
a first substrate including a drive substrate, a plurality of light emitting elements arranged two-dimensionally on the drive substrate and including a plurality of first electrodes, an organic layer arranged on the plurality of first electrodes, and a second electrode that covers the organic layer, and a protective layer that covers the plurality of light emitting elements;
a second substrate including a counter substrate arranged so as to face the drive substrate and a plurality of color filters formed on the counter substrate; and
a sealing resin layer that joins the protective layer of the first substrate and the color filters of the second substrate to each other,
wherein a plurality of subpixels corresponding to the plurality of respective light emitting elements is formed,
a ring-shaped lens including a convex surface portion that is convex in a direction away from the second substrate is provided in a peripheral edge portion of each of the subpixels at a position from which a position across the color filters of an adjacent subpixel adjacent to each of the subpixels is excluded in a plan view of the subpixels, and
a refractive index of the lens is higher than a refractive index of an outer portion of the lens in contact with the convex surface portion.

8. The display device according to claim 1,
wherein a plurality of the first electrodes is formed in a state of being separated from each other according to arrangement of the subpixels,
an insulating layer is formed between the first electrodes adjacent to each other,
the insulating layer includes a plurality of openings,
each of the openings is arranged on a plurality of the respective first electrodes, and
the lens is provided at a position from which a position overlapping with the openings is excluded in a plan view of the subpixels.

9. The display device according to claim 8,
wherein the lens is provided along a peripheral edge of the openings in a plan view of the subpixels.

10. The display device according to claim 1,
wherein the lens has a semicircular, semi-elliptical, trapezoidal, or triangular longitudinal cross-sectional shape.

11. The display device according to claim 1,
wherein the lens includes a material having optical transmissivity.

12. The display device according to claim 1,
wherein the lens includes a photosensitive resin material.

13. The display device according to claim 1,
wherein a convex lens is further provided on the color filters.

14. An electronic device comprising the display device according to claim 1.
